# EUROPEAN PATENT APPLICATION

(11) **EP 4 318 521 A1**
(43) Date of publication of application: **07.02.2024**
(21) Application number: 23182697.5
(22) Date of filing: 30.06.2023
(51) Int. Cl.: H01H 9/54, H01H 33/59, H01H 31/00

(54) **HYBRID CIRCUIT BREAKER SYSTEM WITH INTEGRATED GALVANIC ISOLATING SWITCH**

(30) Priority: 02.08.2022 US 202217879608
(71) Applicant: Rockwell Automation Technologies, Inc., Mayfield Heights, OH 44124 (US)
(72) Inventor: Kerim, Aiman, Mayfield Heights (US); Elmiger, David, Mayfield Heights (US); Langer, Randall S., Mayfield Heights (US); Adkins, Kyle B., Mayfield Heights (US)
(74) Representative: Grünecker Patent- und Rechtsanwälte PartG mbB

(57) **Abstract**

This disclosure describes a hybrid circuit breaker for an industrial automation system. The hybrid circuit breaker may include a breaker switch and a solid-state switching circuit coupled in parallel. Moreover, the hybrid circuit breaker may include a disconnector switch coupled in series with the breaker switch. For example, the solid-state switching circuit may include a number of solid-state devices. A control system may provide control signals to the disconnector switch, the breaker switch, and the solid-state switching circuit to switch on and switch off the hybrid circuit breaker. The hybrid circuit breaker may enable or reduce (e.g., halt) electrical current flow based on receiving the control signals. Operation of the breaker circuit and the solid-state switching circuit that are coupled in parallel may provide reduced heat generation while providing safe switching of the hybrid circuit breaker. Moreover, operation of the disconnector switch may provide galvanic isolation.

## Description

### BACKGROUND

This disclosure relates generally to systems and methods for circuit breakers used within industrial automation systems. More specifically, the present disclosure discusses mechanical and solid-state circuit breakers, which may be used to protect a portion of an industrial automation system.

This section is intended to introduce the reader to various aspects of art that may be related to various aspects of the present techniques, which are described and/or claimed below. This discussion is believed to be helpful in providing the reader with background information to facilitate a better understanding of the various aspects of the present disclosure. Accordingly, it should be understood that these statements are to be read in this light, and not as admissions of prior art.

An industrial automation system may include a variety of components associated with different types of motors and motor-drive configurations. For example, different motor-drive configurations may use different types of protection and electrical isolation systems to protect various electrical components connected to a motor-drive system from certain overvoltage and/or overcurrent situations. To effectively protect and operate a variety of types of motors and electrical systems in an industrial automation system, circuit breakers may be included between an electrical load (e.g., a motor) and a power supply.

### BRIEF DESCRIPTION

A summary of certain embodiments disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects that may not be set forth below.

In an embodiment, a circuit breaker is described. The circuit breaker may include a disconnector switch, a breaker switch coupled in series with the disconnector switch, a solid-state switching circuit, and a processor. An input node may electrically connect to an output node via the disconnector switch and the breaker switch through a first conductive path. The solid-state switching circuit may be coupled in parallel with the breaker switch. Moreover, the solid-state switching circuit may include at least one solid-state switch. The input node may electrically connect to the output node via the disconnector switch and the at least one solid-state switch through a second conductive path. The processor may provide a first set of control signals to the disconnector switch to close when the breaker switch and the solid-state switching circuit are open. The processor may also provide a second set of control signals to the solid-state switching circuit to cause the solid-state switching circuit to close and connect the input node to the second conductive path. Moreover, the processor may provide a third set of control signals to the breaker switch to cause the breaker switch to close and connect the input node to the first conductive path. Furthermore, the processor may provide a fourth set of control signals to the solid-state switching circuit to cause the solid-state switching circuit to open and disconnect the input node from the second conductive path.

In another embodiment, a method is described. The method may include receiving a request to interrupt electrical current flow of a first conductive path of a circuit breaker system by a processor. The circuit breaker system may include a breaker switch and a disconnector switch configured to provide the first conductive path between an input node and an output node of the circuit breaker system. The request may be received when the breaker switch and the disconnector switch are closed and the breaker switch is coupled in series with the disconnector switch. The method may also include transmitting a first set of control signals to a solid-state switching circuit of the circuit breaker system by the processor. The first set of control signals may to cause the solid-state switching circuit to close to provide a second conductive path between the input node and the output node. The second conductive path may include the disconnector switch and the solid-state switching circuit. Moreover, the solid-state switching circuit may be coupled in series with the disconnector switch and in parallel with the breaker switch. The method may further include transmitting a second set of control signals to the breaker switch by the processor. The second set of control signals may cause the breaker switch to open, thereby diverting at least a portion of the electrical current through the second conductive path. Furthermore, the method may include transmitting a third set of control signals to the solid-state switching circuit by the processor. The third set of control signals may cause the solid-state circuit switch to open, thereby reducing the electrical current flow through the circuit breaker system.

In yet another embodiment, a tangible, non-transitory, machine-readable medium, including machine-readable instructions that, when executed by a processor, cause the processor to perform actions is described. The actions may include receiving a request to conduct electrical current flow through a circuit breaker system by a processor. The actions may also include transmitting a first set of control signals to a solid-state switching circuit of the circuit breaker system by the processor and in response to receiving the request. The first set of control signals may cause the solid-state switching circuit to provide a first conductive path between an input node and an output node of the circuit breaker system. The actions may also include transmitting a second set of control signals by the processor to a breaker switch of the circuit breaker system coupled in parallel to the solid-state switching circuit. The second set of control signals may cause the breaker switch to provide a first conductive path between the input and the output and divert a first portion of the electrical current to the first conductive path when the solid-state switching circuit is closed. Moreover, the actions may include transmitting a third set of control signals to the solid-state switching circuit by the processor. The third set of control signals may cause the solid-state switching circuit to open the second conductive path, thereby diverting a second portion of the electrical current to the first conductive path.

### DRAWINGS

These and other features, aspects, and advantages of the present disclosure will become better understood when the following detailed description is read with reference to the accompanying drawings in which like characters represent like parts throughout the drawings, wherein:
FIG. 1 is a block diagram of a feeder system including a hybrid circuit breaker which may be part of an industrial automation system, in accordance with embodiments described herein;
FIG. 2 is a circuit diagram of the hybrid circuit breaker of the feeder system of FIG. 1, in accordance with embodiments described herein;
FIG. 3 is a flowchart of a process for enabling electrical current flow through the hybrid circuit breaker of FIGS. 1 and 2, in accordance with embodiments described herein; and
FIG. 4 is a flowchart of a process for switching off the hybrid circuit breaker to halt the electrical current flow through the hybrid circuit breaker, in accordance with embodiments described herein.

### DETAILED DESCRIPTION

One or more specific embodiments of the present disclosure will be described below. In an effort to provide a concise description of these embodiments, all features of an actual implementation may not be described in the specification. It should be appreciated that in the development of any such actual implementation, as in any engineering or design project, numerous implementation-specific decisions must be made to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of this disclosure.

When introducing elements of various embodiments of the present disclosure, the articles "a," "an," "the," and "said" are intended to mean that there are one or more of the elements. The terms "comprising," "including," and "having" are intended to be inclusive and mean that there may be additional elements other than the listed elements. As used herein, "in-line" refers to a longitudinal axis of a drive module or a component of a drive module arranged parallel with a rotational axis of a rotor of a motor. As used herein, "potting" refers to covering electronic components (e.g., circuitry) and/or filling an assembly containing electronic components with a solid or gelatinous material to prevent adverse environmental factors (e.g., water, moisture, corrosion, and so forth) and/or adverse effects from physical forces (e.g., impacts, shocks, vibrations, and so forth). As used herein, "power conversion" refers to converting alternating current into direct current, converting direct current into alternating current, altering a voltage of a current, or altering a frequency of a current, or any combination thereof.

The current disclosure is related to a hybrid circuit breaker system including a number of mechanical switches and solid-state switches. In particular, the hybrid circuit breaker system, hereinafter referred to as the hybrid circuit breaker, may include an air-gap disconnector, a breaker switch, and a solid-state switching circuit. The solid-state switching circuit may include a number of solid-state switches. The solid-state switching circuit may couple in parallel to the breaker switch (e.g., parallel switch). The air-gap disconnector may couple in series to the solid-state switching circuit. In some cases, an industrial automation system may include the hybrid circuit breaker to control the supply of alternating current (AC) current from a generator to a load.

The hybrid circuit breaker may receive control signals from a control system or a processor to open and close the air-gap disconnector, the breaker switch, and the solid-state switches of the solid-state switching circuit. That is, the control system may control electrical current flow through the hybrid circuit breaker based on the control signals. In some cases, the control system may provide the control signals to close the hybrid circuit breaker to allow the electrical current to flow to load devices.

For example, the control system may provide the control signals to the hybrid circuit breaker to cause the air-gap disconnector to close. The control system may provide additional control signals to cause the solid-state switches of the solid-state switching circuit to close and to cause the breaker switch to open. Subsequently, the control system may provide additional control signals to the breaker switch to cause it to close. In this way, the hybrid circuit breaker including the breaker switch and the solid-state switching circuity may enable controlled and safe electrical current flow through the hybrid circuit breaker to improve (e.g., increase) reliability and lifespans of systems using the hybrid circuit breakers. Moreover, operations of the breaker switch and the solid-state switching circuity coupled in parallel may enable providing for reduced size and/or cost of the solid-state switches.

Moreover, the control system may also provide the control signals to cause the hybrid circuit breaker to switch off, thereby interrupting the electrical current flow. In particular, the control system may provide the control signals to the hybrid circuit breaker that cause the air-gap disconnector and the breaker switch to open while causing the solid-state switches to switch the solid-state switching circuit on and off. As such, the electrical current may flow briefly through the solid-state switching circuit when attempting to stop the electrical current flow through the hybrid circuit breaker, as will be appreciated.

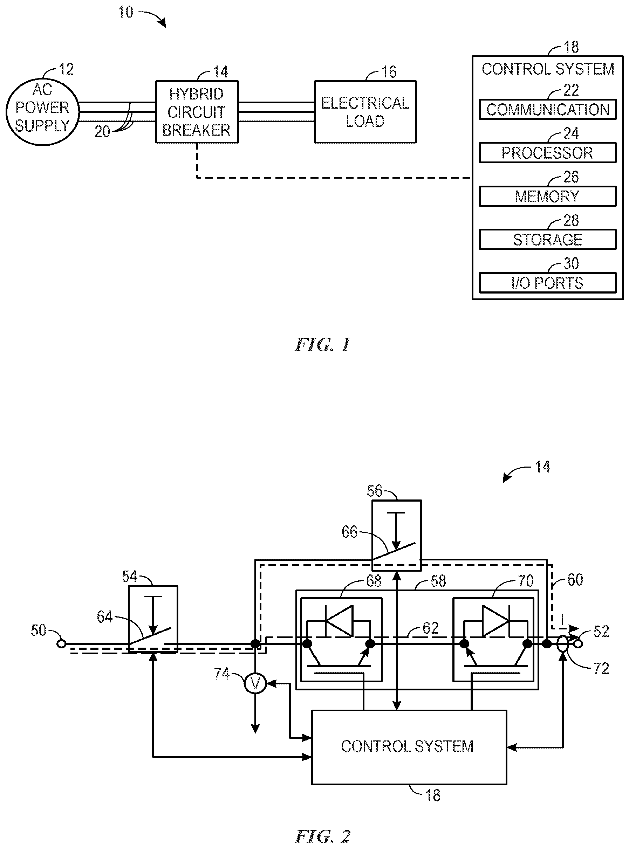

In such cases, the breaker switch and the solid-state switching circuit may advantageously reduce an amount of heat generated when switching the hybrid circuit breaker on or off. By reducing the amount of heat generated for switching operations, the hybrid circuit may advantageously include smaller solid-state switching circuit with smaller solid-state switches, as compared to using just the air-gap disconnect in series with the solid-state switching circuit. Moreover, by employing the solid-state switching circuit as described herein may reduce wear and damages that may occur to the mechanical switch of the breaker switch due to the reduced heat and arcing properties experienced by the breaker switch. Additional details with regard to the embodiments described above will be details below with reference to FIGS. 1-4.

By way of introduction, FIG. 1 is a block diagram of a feeder system 10 (e.g., motor feeder system, motor control center (MCC) feeder system), which may be part of an industrial automation system. The feeder system 10 may include a power supply, such as an alternating current (AC) power supply 12, to supply power to loads coupled downstream. The feeder system 10 may also include a hybrid circuit breaker 14 coupled to the AC power supply 12. The AC power supply 12 may supply current and/or voltage to an electrical load 16 coupled to the hybrid circuit breaker 14.

In some cases, when abnormal operation occurs, such as when a voltage that is uncharacteristically high or low is delivered to the electrical load 16, the hybrid circuit breaker 14 may electronically disconnect the AC power supply 12 from the electrical load 16. As such, the hybrid circuit breaker 14 may protect the electrical load 16 from supply voltages and/or supply currents that may damage the hybrid circuit breaker 14.

Any suitable number of supply devices may be represented by the AC power supply 12, such as any combination of rectifiers, converters, power banks, generation devices, or the like. It should be understood that the feeder system 10 may include one or more motor-drive systems, motors, MCCs, or the like as the electrical load, coupled between any of the depicted devices and that the feeder system 10 may include one or more additional components not depicted in FIG. 1.

For example, the feeder system 10 may include any suitable type of rectifier device that includes a number of switches controllable by any suitable power converter. For example, the AC power supply 12 may include an active front end (AFE) converter, a diode converter, a thyristor converter, a diode front end rectifier, or the like. In some embodiments, the switches of the AC power supply 12 may be semiconductor-controlled devices, transistor-based (e.g., insulated-gate bipolar transistor (IGBT), metal-oxide semiconductor field-effect transistor (MOSFET), or other suitable transistor) devices, or other suitable devices in which the opening and/or closing of the switch may be controlled using an external signal (e.g., gate signal), which may be provided by the control system 18. The AC power supply 12 may provide AC supply signals (e.g., AC voltage, AC current, a regulated AC output) on a bus 20, which may be provided to the hybrid circuit breaker 14. In some cases, the bus 20 may include three transmission lines for providing each phase of a three-phased electrical power to the electrical load 16 via a dedicated hybrid circuit breaker 14.

Industrial automation systems may operate in response to signals generated by the control system 18. The control system 18 may include any suitable number of electronic devices and/or components to generate and/or manage generation of the control signals. For example, the control system 18 may include a communication component 22, a processor 24, a memory 26, storage 28, and input/output (I/O) ports 30, or the like, for generating and managing generation of control signals.

The communication component 22 may be a wireless or wired communication component that facilitates communication between the control system 18, the hybrid circuit breaker 14, or other suitable electronic devices. The processor 24 may be any type of computer processor or microprocessor capable of executing computer-executable code. The memory 26 and the storage 28 may be any suitable articles of manufacture that may serve as media to store processor-executable code, data, or the like. These articles of manufacture may represent computer-readable media (i.e., any suitable form of memory or storage) that may store the processor-executable code used by the processor 24 to perform the presently disclosed techniques, such as to predictively respond to operational changes, or the like.

The I/O ports 30 may couple to one or more sensors, one or more input devices, one or more displays, or the like, to facilitate human or machine interaction with the control system 18, the hybrid circuit breaker 14, or other suitable electronic devices. For example, based on a notification provided to the operator via a display, the operator may use an input device to instruct the adjustment of a parameter associated with the hybrid circuit breaker 14.

Keeping the foregoing in mind, sometimes the control system 18 may communicate with the hybrid circuit breaker 14 using one or more communication techniques. For example, the hybrid circuit breaker 14 may include a controller area network (CAN) communicative coupling and/or an internet protocol (IP)-based communicative coupling, such as an Ethernet IP communicative coupling, to the control system 18. These communicative couplings may enable the hybrid circuit breaker 14 to communicate with the control system 18 without intervention from a host computer. Thus, the hybrid circuit breaker 14 may communicate directly with the control system 18 without using an intervening computing device.

In some cases, the control system 18 may use one or more configuration interfaces to communicate with the hybrid circuit breaker 14. The configuration interface may be a graphical user interface and/or logically-defined data object (e.g., data table) that permits the control system 18 and/or user to provide and/or update a configuration and/or to obtain a status of the hybrid circuit breaker 14. In this way, the configuration interface may be a data boundary used to translate configurations from devices external to the hybrid circuit breaker 14 to a format readable by the hybrid circuit breaker 14 and/or to translate statuses from the hybrid circuit breaker 14 into a format readable by devices external to the hybrid circuit breaker 14.

The control system 18 may also permit configuration of properties of the hybrid circuit breaker 14 based at least in part on thermal measurements and/or metering information, such as phase-phase voltages, phase-to-ground voltages, input current, output current, frequency, power, status of the hybrid circuit breaker 14 (e.g., Open, Close, Blocked, Failure), or the like. In this way, the control system 18 may determine a current operation of the hybrid circuit breaker 14 and use the information of the current operation to determine how to adjust an operation of the hybrid circuit breaker 14. For example, the control system 18 may determine that a failure is present on the hybrid circuit breaker 14 and has a thermal measurement higher than a historical average for the hybrid circuit breaker 14. Using this information, the control system 18 may determine that an undesired operational state is present, and thus may determine to open the hybrid circuit breaker 14. Furthermore, the control system 18 may use this information to operate other devices upstream and/or downstream of the hybrid circuit breaker 14, such as controlling additional protection circuitry to further isolate the hybrid circuit breaker 14 from the industrial automation system.

The properties, in some embodiments, may also be used to define operation limits corresponding to determined settings to be used to protect the load. The operation limits may correspond to operating ranges set by governing agencies or standard committees, such as American National Standards Institute (ANSI^{®}), Underwriters Laboratories (UL^{®}), International Electrotechnical Commission (IEC^{®}) or the like, and may be used to protect the hybrid circuit breaker 14, the electrical load 16, or the like from undesired operating conditions. Furthermore, the properties may also define protection groups or classes associated with the hybrid circuit breaker 14. Protection groups or classes may correspond to groups of electrical loads 16 that may have a same protection scheme. These protection groups or classes may be classifications of types of protection for different devices set by governing agencies or standard committees.

When the electrical load 16 is classified as part of a protection group with another electrical load 16, it may be desired to protect both electrical loads 16 with a hybrid circuit breaker 14 set to the same settings. In this way, when a different electrical load 16 is installed to the hybrid circuit breaker 14, the protection groups or classes may be updated to indicate the new group or class of the new electrical load 16. This may cause the hybrid circuit breaker 14 to automatically update its operational settings to accommodate one or more properties of the new electrical load 16. Use of the protection groups may thus improve deployment of setting changes to the hybrid circuit breakers 14 by making an overall installation process of a new electrical load 16 relatively faster since less time is spent updating operational settings of the hybrid circuit breaker 14.

In some embodiments, the hybrid circuit breaker 14 may detect a protection group or class of its electrical load 16 automatically and/or without receiving the property from the control system 18. In these cases, the hybrid circuit breaker 14 may sense metering information (e.g., operational properties) of the electrical load 16 to determine or identify a protection group or class that applies to the electrical load 16. For example, the hybrid circuit breaker 14 may determine that it outputs single-phase power and that its load is operating at a relatively high voltage that corresponds to an operating voltage of a particular motor load, thus the hybrid circuit breaker 14 may automatically classify its electrical load 16 as a motor class (e.g., certain rated voltage) based on this analysis. For example, a dedicated hybrid circuit breaker 14 may couple to each of the three transmission lines of the bus 20 to open or short a connection of a respective phase of the three-phased power between the AC power supply 12 and the electrical load 16.

FIG. 2 is a circuit diagram of the hybrid circuit breaker 14 (e.g., the hybrid circuit breaker chip). The hybrid circuit breaker 14 may control electrical current flow between an input 50 and an output 52 of the hybrid circuit breaker 14. The hybrid circuit breaker 14 may include a disconnector switch 54, a breaker switch 56, and a solid-state switching circuit 58. Moreover, the disconnector switch 54, the breaker switch 56, and the solid-state switching circuit 58 may provide a first conductive path 60 and/or a second conductive path 62 between the input 50 and the output 52 of the hybrid circuit breaker 14. In the depicted embodiment, the breaker switch 56 may couple in parallel to the solid-state switching circuit. Moreover, the disconnector switch 54 may couple in series to the solid-state switching circuit 58.

In some cases, the disconnector switch 54 may include a mechanical switch 64. The mechanical switch 64 of the disconnector switch 54 may remain closed (e.g., or open) when the breaker 56, the solid-state switching circuit 58, or both are in a closed state. Accordingly, in specific cases, the mechanical switch 64 of the disconnector 54 may switch to a closed state or an open state when the breaker switch 56 and/or the solid-state switching circuit 58 are in an open state. Moreover, the breaker switch 56 may also include a mechanical switch 66 to provide the first conductive path 60 between the input 50 and the output 52 when the disconnector switch 54 is in a closed state. In some cases, the disconnector switch 54 and/or the breaker switch 56 may include a solenoid, or any other viable magnetic actuator (e.g., a solenoid) or mechanical actuator to cause the mechanical switch 64 and the mechanical switch 66, respectively, to move. In some cases, the disconnector switch 54 and/or the breaker switch 56 may receive control signals to open and close the mechanical switch 64 and the mechanical switch 66, respectively, based on operating the magnetic actuator.

The solid-state switching circuit 58 may include a number of solid-state switches (e.g., transistors, MOSFETs) to provide the second conductive path 62 when the disconnector switch 54 is in the closed state. In the depicted embodiment, the solid-state switching circuit 58 may include a first solid-state switch 68 and a second solid-state switch 70. The first solid-state switch 68 and the second solid-state switch 70 may include semiconductor-controlled devices, IGBTs, MOSFETs, or other suitable transistor devices, metal-oxide-semiconductor-controlled thyristors (thyristors), vertical metal oxide semiconductors or V-groove MOSs (VMOSs), laterally-diffused metal-oxide semiconductors (LDMOSs), diodes or other suitable devices in which the opening and/or closing of the solid-state switch may be controlled using an external signal (e.g., gate signal), which may be provided by the control system 18 (e.g., the processor 24).

In some cases, the first solid-state switch 68 and the second solid-state switch 70 may receive a control signal to control the opening and closing of the second conductive path 62. By way of operation, the first solid-state switch 68 and the second solid-state switch 70 may be capable of opening and closing faster than the mechanical switch 64 and the mechanical switch 66 may be capable of opening and closing. Accordingly, incorporating the first solid-state switch 68 and the second solid-state switch 70 with the mechanical switch 64 and the mechanical switch 66 may provide additional functionality and benefits when operating the hybrid circuit breaker 14 (e.g., the hybrid circuit breaker system), as will be appreciated.

As shown in the depicted embodiments, a source of the first solid-state switch 68 may couple to a drain of the second solid-state switch 70. A source of the first solid-state switch 68 may couple to the disconnector switch 54 in series and to a first side of the breaker switch 56. A source of the second solid-state switch 70 may couple to the output 52 and a second side of the breaker switch 56. In some cases, the first solid-state switch 68 and the second solid-state switch 70 may receive control signals (e.g., gate signals) to connect the second conductive path 62 between the input 50 to the output 52.

The control system 18 (e.g., the processor 24) may generate control signals to operate the disconnector switch 54, the breaker switch 56, and the solid-state switching circuit 58. In some cases, the control system 18 may enable electrical current flow by way of the first conductive path 60, the second conductive path 62, or both between the input 50 and the output 52. Moreover, the control system 18 may provide the control signals to disrupt the electrical current flow by opening the first conductive path 60 and the second conductive path 62, as will be appreciated.

By way of operation, the control system 18 may use a configuration profile for controlling the electrical current flow via the hybrid circuit breaker 14. For example, the configuration profile may include instructions to ramp up the electrical current flow based on a predetermined profile and/or ramp down the electrical current flow based on a predetermined profile. In specific cases, the processor 24 may retrieve the configuration profile stored on the memory 26 and/or the storage 28. To determine whether the hybrid circuit breaker 14 is providing the electrical current flow according to the profile, the control system 18 may receive a current measurement from a current sensor 72, a voltage measurement from a voltage sensor 74, or a feedback signal from the electrical load 16 that may be used to verify whether the profiles are being implemented.

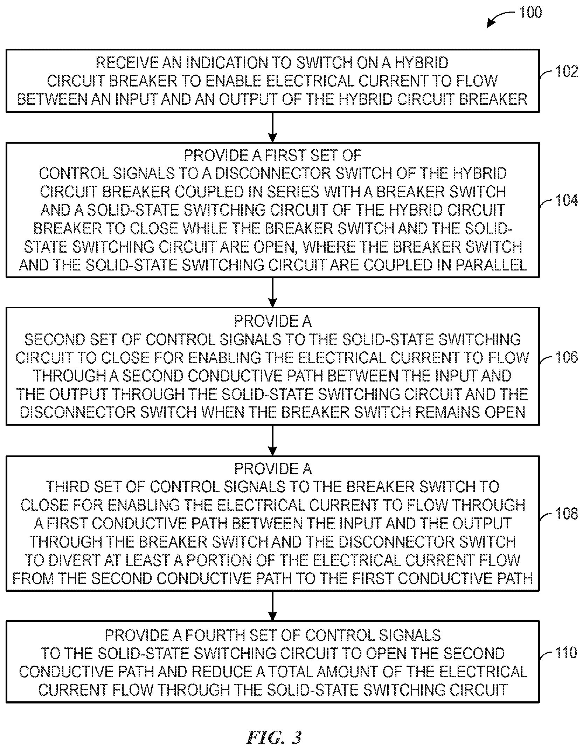

With the foregoing in mind, FIG. 3 is a process 100 for enabling electrical current flow through the hybrid circuit breaker 14 via the disconnector switch 54, the breaker switch 56, and the solid-state switching circuit 58. Although the processor 24 is described as performing the blocks of the process 100, it should be understood that any suitable computing or control system may perform the process 100. Moreover, although specific blocks are described herein, in alternative or additional embodiments, one or more additional blocks may be included, one or more of the blocks may be omitted, and/or one or more of the blocks may include different processes. Additionally, although the blocks are described in a particular order, in different embodiments, the processor 24 may perform the processes of the blocks in any viable order.

Referring now to FIG. 3, at block 102, the processor 24 may receive an indication to switch on the hybrid circuit breaker 14 to enable (e.g., increase) the electrical current flow between the input 50 and the output 52. In some cases, the indication may be related to a request to switch on the electrical load 16. For example, one or more sensors or any other viable circuit component of the feeder system 10 may provide the request. Alternatively or additionally, a user may initiate the request. In any case, the electrical load 16 may include a motor that may switch on based on receiving AC current from the AC power supply 12 when the hybrid circuit breaker 14 is switched on (e.g., closed).

At block 104, the processor 24 may provide a first set of control signals to the disconnector switch 54 to close in response to receiving the indication or request. The first set of control signals may be sent when the breaker switch 56 and the solid-state switching circuit 58 are open. Each set of control signals may include one or multiple signals. In specific cases, the processor 24 may only close the disconnector switch 54 when the breaker switch 56 and the solid-state switching circuit 58 are open to reduce possible damages to the disconnector switch 54 due to electrical arcing when current is present on the disconnector switch 54 when opening. As such, the disconnector switch 54 may become closed when the first conductive path 60 and the second conductive path 62 are open and the hybrid circuit breaker 14 may not have electrical current (e.g., 0 amperes (A), near 0 A) flow through it initially.

At block 106, the processor 24 may provide a second set of control signals to the solid-state switching circuit 58 to enable the electrical current to flow through the second conductive path 62 while the breaker switch 56 remains open. As mentioned above, in some cases, the processor 24 may provide the second set of control signals to the first solid-state switch 68 and/or the second solid-state switch 70 to ramp up the electrical current flow through the hybrid circuit breaker 14 according to a configuration profile. In such cases, the configuration profile may be associated with controlling operations of a load device (e.g., a motor, a rotational speed of the motor), an amount of current flow increase through the solid-state switching circuit over time, a voltage increase of the solid-state switching circuit 58 over time, among other things. Moreover, as mentioned above, the processor 24 may retrieve the configuration profile stored on the memory 26 and/or the storage 28.

In some embodiments, the processor 24 may control (e.g., ramp up) the electrical current flow through the second conductive path 62 according to the configuration profile based on receiving one or more feedback signals (e.g., current and/or voltage measurements). For example, the processor 24 may receive feedback signals indicative of an operation status of the load device (e.g., rotational speed of the motor) and the like. Moreover, the processor 24 may receive one or more current and/or voltage measurements from the current sensor 72, the voltage sensor 74, or other sensors (not shown in FIG. 2) that may be positioned at different nodes of the hybrid circuit breaker 14, as well as the AC power supply 12, the bus 20, the electrical load 16, among other positions.

Subsequently, at block 108, the processor 24 may provide a third set of control signals to the breaker switch 56 to enable the electrical current flow through the first conductive path 60 via the breaker switch 56, thereby diverting (e.g., commutating) at least a portion of the electrical current flow from the second conductive path 62 to the first conductive path 60. For example, the processor 24 may transmit the third set of control signals after a predetermined time period (e.g., 1 mili-second (ms), 0.5 ms, 0.1 s, and so on) or when a current of the second conductive path 62 reaches a threshold, a voltage of one conductive path reaches a threshold, an operation status of the load device changes, based on receiving an indication, and the like. In some cases, the mechanical switch 66 of the breaker switch 56 may have a lower resistance in the closed state compared to the first solid-state switch 68, the second solid-state switch 70, or both in the closed state. Accordingly, at least a portion of the electrical current may flow through the first conductive path 60 (e.g., commutate to the first conductive path) when the first conductive path 60 and the second conductive path 62 are closed.

As such, at block 110, the processor 24 may provide a fourth set of control signals to the solid-state switching circuit 58 to open the second conductive path 62 via the solid-state-switching circuit 58. Opening the second conductive path 62 may divert (e.g., cause commutation of) the electrical current flow to the breaker switch 56. Accordingly, the processor 24 may provide the fourth set of control signals to the solid-state switching circuit 58 to reduce a total amount of the electrical current flow through the solid-state switching circuit 58 (e.g., the first solid-state switch 68 and/or the second solid-state switch 70). In some cases, the reduced electrical current flow through the solid-state switching circuit 58 may reduce a wear and/or a probability of failure of the first solid-state switch 68 and/or the second solid-state switch 70. Moreover, the reduced electrical current flow through the solid-state switching circuit 58 may allow reducing a size and/or reducing a cost of the first solid-state switch 68 and/or the second solid-state switch 70.

Accordingly, when starting the hybrid circuit breaker 14, the solid-state switching circuit 58 may provide additional benefits by reducing a probability of failures by controlling switch on procedure of the hybrid circuit breaker 14 and/or controlling switch on procedure of the electrical load 16. Moreover, diverting (e.g., commutating) the electrical current flow to the breaker switch 56 may reduce heat generation of the solid-state switching circuit 58. As such, operations of the hybrid circuit breaker 14 (e.g., the hybrid circuit breaker chip) including parallel breaker (e.g., the breaker switch 56) and solid-state switches (e.g., the solid-state switching circuity 58) may enable controlled and safe electrical current flow while providing for reduced size and/or cost of the solid-state switches (e.g., the first solid-state switch 68 and the second solid-state switch 70). The hybrid circuit breaker 14 may provide further benefits when halting the electrical current flow, for example, to stop operations (e.g., rotation) of a motor of the electrical load 16, as will be appreciated.

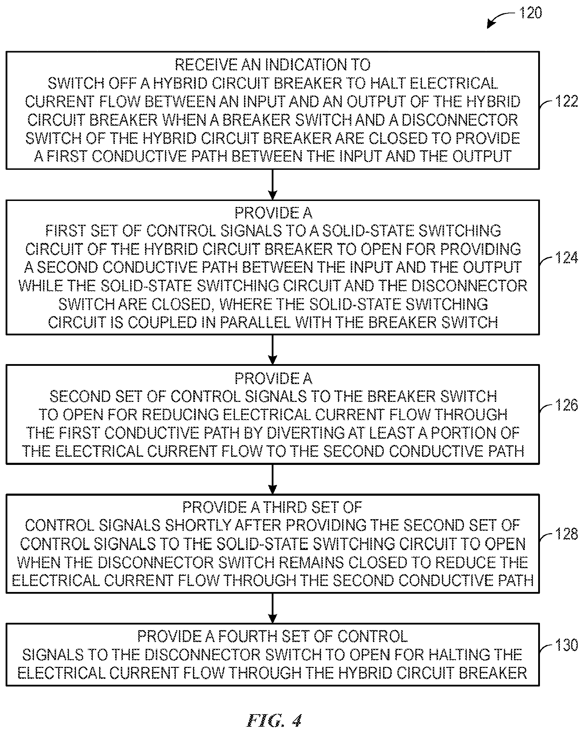

FIG. 4 is a process 120 for switching off the hybrid circuit breaker to halt the electrical current flow through the hybrid circuit breaker 14 when the disconnector switch 54 and the breaker switch 56 are closed and the solid-state switching circuit 58 is open. Initially, the electrical current may flow through the first conductive path 60 as the disconnector switch 54 and the breaker switch 56 are closed. Although the processor 24 is described as performing the blocks of the process 100, it should be understood that any suitable computing or control system may perform the process 100. Moreover, although specific blocks are described herein, in alternative or additional embodiments, one or more additional blocks may be included, one or more of the blocks may be omitted, and/or one or more of the blocks may include different processes. Additionally, although the blocks are described in a particular order, in different embodiments, the processor 24 may perform the processes of the blocks in any viable order.

In any case, at block 122, the processor 24 may receive an indication to switch off the hybrid circuit breaker 14 to halt, reduce, and/or interrupt the electrical current flow between the input 50 and the output 52. In some cases, the indication may be related to a request to switch off the electrical load 16. In some cases, one or more sensors and/or a user, among other things may provide the request. For example, the one or more sensors may provide the request based on detecting a high current, a high voltage, a user input, an anomalous behavior of the feeder system 10, among other possibilities. In any case, the electrical load 16 may include a motor that may switch off based on halting the electrical current flow when the hybrid circuit breaker 14 is switched off (e.g., opened).

To halt the electrical current flow, at block 124, the processor 24 may provide a first set of control signals to the solid-state switching circuit 58 to close in response to receiving the indication or request. The first solid-state switch 68, the second solid-state switch 70, or both may become closed based on receiving the first set of control signals. Accordingly, the solid-state switching circuit 58 may provide the second conductive path 62.

As mentioned above, in some cases, the resistance of the mechanical switch 66 of the breaker switch 56 in the closed state (e.g., 0.1 mili-ohms (mΩ), 0.5 mΩ, 1 mΩ, and so on) is less than the resistance of the first solid-state switch 68, the second solid-state switch 70, or both in the closed state (e.g., 1 mΩ, 5 mΩ, 10 mΩ, and so on). Accordingly, a portion of (e.g., all of, most of) the electrical current may flow through the first conductive path 60 based on a lower resistance of the first conductive path 60 compared to the second conductive path 62. In some cases, a remaining portion (e.g., near 0, a small portion) of the electrical current may flow through the second conductive path 62.

In any case, at block 126, the processor 24 may provide a second set of control signals to the breaker switch 56 to open while the solid-state switching circuit 58 and the disconnector switch 54 remain closed. Opening the breaker switch 56 may divert an increasing portion of the electrical current to flow through the second conductive path 62. In particular, the increasing portion of the electrical current may flow through the solid-state switching circuit 58 as a resistance of the breaker switch 56 increase when opening the mechanical switch 66.

Moreover, the electrical current flow through the solid-state switching circuit 58 may cause maintaining a differential voltage across the breaker switch 56 below a threshold (e.g., 0 volt (V), 0.1 V, 0.5 V, and so on) as the mechanical switch 66 is opening. As such, in some cases, the solid-state switching circuit 58 may reduce an arc current on the mechanical switch 66 of the breaker switch 56 when closing the breaker switch 56 while the solid-state switching circuit 58 and the disconnector switch 54 remain closed. Accordingly, the solid-state switching circuit 58 may reduce (e.g., or eliminate) an adverse effect of the electrical arcs on the mechanical switch (or the hybrid circuit breaker 14) and improve (e.g., increase) reliability and lifespans of systems using the hybrid circuit breakers 14.

At block 128, the processor 24 may provide a third set of control signals to the solid-state switching circuit 58 to open when the disconnector switch 54 remains closed. In some cases, the processor 24 may provide the third set of control signals shortly after providing the second set of control signals based on a wavelength of the electrical current. For example, in different cases, the processor 24 may provide the third set of control signals ¼ cycle, ½ cycle, ¾ cycle, 1 cycle, and so on, after providing the second set of control signals. Alternatively or additionally, in different cases, the processor 24 may provide the third set of control signals 1 ms, 3 ms, 5 ms, 10 ms, 0.1 s, 0.5 s, and so on, after providing the second set of control signals.

In any case, opening the solid-state switching circuit 58 and the breaker switch 56 may substantially reduce the electrical current flow (e.g., ., 0 A, near 0 A) through the hybrid circuit breaker 14 based on opening the first conductive path 60 and the second conductive path 62. Moreover, and as mentioned above, opening the solid-state switching circuit 58 after opening the breaker switch 56 may reduce a differential voltage across the breaker switch 56 to reduce the arc current in some instances. Furthermore, opening the solid-state switching circuit 58 shortly after opening the breaker switch 56 may reduce a total amount of the electrical current that may flow through the solid-state switching circuit 58 before opening the second conductive path 62.

For example, the first solid-state switch 68 and the second solid-state switch 70 may receive a reduced amount of electrical current based on the electrical current commutating to the second conductive path 62 for a short period of time (e.g., less than 1 ms, less than 3 ms, less than 5 ms, less than 10 ms, less than 0.1 s, less than 0.5 s, and so on). Moreover, the first solid-state switch, the second solid-state switch, or both, may generate less heat based on the reduced amount of the electrical current flowing through the first solid-state switch and the second solid-state switch. Accordingly, the first solid-state switch, the second solid-state switch, or both may be implemented using smaller and/or less expensive semi-conductor devices (e.g., IGBTs, silicon carbide, etc.).

Subsequently, at block 130, the processor 24 may provide a fourth set of control signals to the disconnector switch 54 to open while the breaker switch 56 and the solid-state switching circuit 58 are open. As such, the processor 24 may provide the fourth set of control signals to halt the electrical current flow through the hybrid circuit breaker. Opening the disconnector switch 54 may provide a physical disconnect (e.g., an air gap) between the input 50 and the output 52 of the hybrid circuit breaker 14 (e.g., the hybrid circuit breaker chip). Accordingly, the disconnector switch 54 may provide a galvanic isolation in series to the breaker switch 56 and the solid-state switching circuit 58.

While the present disclosure may be susceptible to various modifications and alternative forms, specific embodiments have been shown by way of example in the drawings and have been described in detail herein. However, it should be understood that the present disclosure is not intended to be limited to the particular forms disclosed. Rather, the present disclosure is intended to cover all modifications, equivalents, and alternatives falling within the spirit and scope of the present disclosure as defined by the following appended claims.

The techniques presented and claimed herein are referenced and applied to material objects and concrete examples of a practical nature that demonstrably improve the present technical field and, as such, are not abstract, intangible or purely theoretical. Further, if any claims appended to the end of this specification contain one or more elements designated as "means for [perform]ing [a function]..." or "step for [perform]ing [a function]...", it is intended that such elements are to be interpreted under 35 U.S.C. 112(f). However, for any claims containing elements designated in any other manner, it is intended that such elements are not to be interpreted under 35 U.S.C. 112(f).

**The following is a list of further embodiments of the invention:**
Embodiment 1. A circuit breaker system comprising:
   a disconnector switch;
   a breaker switch coupled in series with the disconnector switch, wherein an input node is configured to electrically connect to an output node via the disconnector switch and the breaker switch through a first conductive path;
   a solid-state switching circuit coupled in parallel with the breaker switch, wherein the solid-state switching circuit comprises at least one solid-state switch, and wherein the input node is configured to electrically connect to the output node via the disconnector switch and the at least one solid-state switch through a second conductive path; and
   a processor configured to perform operations comprising:
      providing a first set of control signals to the disconnector switch to close when the breaker switch and the solid-state switching circuit are open;
      providing a second set of control signals to the solid-state switching circuit to cause the solid-state switching circuit to close and connect the input node to the second conductive path;
      providing a third set of control signals to the breaker switch to cause the breaker switch to close and connect the input node to the first conductive path; and
      providing a fourth set of control signals to the solid-state switching circuit to cause the solid-state switching circuit to open and disconnect the input node from the second conductive path.
Embodiment 2. The circuit breaker system of embodiment 1, wherein the breaker switch comprises a magnetic actuator configured to open and close the breaker switch.
Embodiment 3. The circuit breaker system of embodiment 1, comprising a voltage sensor, a current sensor, or both, wherein the processor is configured to perform the operations comprising:
   receiving one or more measurement signals from the voltage sensor, the current sensor, or both,; and
   providing the first set of control signals, the second set of control signals, the third set of control signals, the fourth set of control signals, or any combination thereof based on the one or more measurement signals.
Embodiment 4. The circuit breaker system of embodiment 1, wherein the solid-state switching circuit comprises a first solid-state switch and a second solid-state switch.
Embodiment 5. The circuit breaker system of embodiment 4, wherein a drain of the first solid-state switch is coupled to the disconnector switch, a source of the first solid-state switch is coupled to a drain of the second solid-state switch, and a source of the second solid-state switch is coupled to the output node.
Embodiment 6. The circuit breaker system of embodiment 1, comprising providing the first set of control signals to the disconnector switch when the breaker switch and the solid-state switching circuit are open.
Embodiment 7. A method comprising:
   receiving, by a processor, a request to interrupt electrical current flow of a first conductive path of a circuit breaker system, wherein the circuit breaker system comprises a breaker switch and a disconnector switch configured to provide the first conductive path between an input node and an output node of the circuit breaker system, wherein the request is received when the breaker switch and the disconnector switch are closed, and wherein the breaker switch is coupled in series with the disconnector switch;
   transmitting, by the processor, a first set of control signals to a solid-state switching circuit of the circuit breaker system, wherein the first set of control signals is configured to cause the solid-state switching circuit to close, thereby providing a second conductive path between the input node and the output node, wherein the second conductive path comprises the disconnector switch and the solid-state switching circuit, wherein the solid-state switching circuit is coupled in series with the disconnector switch and in parallel with the breaker switch;
   transmitting, by the processor, a second set of control signals to the breaker switch, wherein the second set of control signals is configured to cause the breaker switch to open, thereby diverting at least a portion of the electrical current flow through the second conductive path; and
   transmitting, by the processor, a third set of control signals to the solid-state switching circuit, wherein the third set of control signals is configured to cause the solid-state switching circuit to open, thereby reducing the electrical current flow through the circuit breaker system.
Embodiment 8. The method of embodiment 7, comprising transmitting, by the processor, a fourth set of control signals in response to opening the solid-state switching circuit, wherein the fourth set of control signals is configured to cause the disconnector switch to open and interrupt the electrical current flow through the circuit breaker system.
Embodiment 9. The method of embodiment 8, wherein the fourth set of control signals is configured to cause the disconnector switch to open a mechanical switch of the disconnector switch via a magnetic actuator.
Embodiment 10. The method of embodiment 8, wherein the fourth set of control signals is configured to cause the disconnector switch to provide an air gap between the input node and the output node by opening the disconnector switch.
Embodiment 11. The method of embodiment 7, comprising transmitting the third set of control signals to the solid-state switching circuit to cause the solid-state circuit switch to open after opening the breaker switch.
Embodiment 12. The method of embodiment 7, wherein transmitting the first set of control signals comprises transmitting the first set of control signals to a first solid-state switch, a second solid-state switch, or both of the solid-state switching circuit, wherein the first set of control signals is configured to cause the solid-state switching circuit to close.
Embodiment 13. The method of embodiment 7, wherein transmitting the first set of control signals comprises transmitting the second set of control signals to an actuator configured to open a mechanical switch associated with the breaker switch.
Embodiment 14. A method comprising: receiving, by a processor, a request to conduct electrical current flow through a circuit breaker system;
   transmitting, by the processor, a first set of control signals to a solid-state switching circuit of the circuit breaker system in response to receiving the request, wherein the first set of control signals is configured to cause the solid-state switching circuit to provide a first conductive path between an input node and an output node of the circuit breaker system;
   transmitting, by the processor, a second set of control signals to a breaker switch of the circuit breaker system coupled in parallel to the solid-state switching circuit, wherein the second set of control signals is configured to cause the breaker switch to provide a second conductive path between the input node and the output node and divert a first portion of the electrical current flow to the second conductive path when the solid-state switching circuit is closed; and
   transmitting, by the processor, a third set of control signals to the solid-state switching circuit, wherein the third set of control signals is configured to cause the solid-state switching circuit to open the first conductive path, thereby diverting a second portion of the electrical current flow to the second conductive path.
Embodiment 15. The method of embodiment 14, comprising transmitting, by the processor, a fourth set of control signals to a disconnector switch coupled in series to the breaker switch before transmitting the first set of control signals, wherein the fourth set of control signals to is configured to cause the disconnector switch to close.
Embodiment 16. The method of embodiment 15, wherein the disconnector switch is configured to provide an air gap between the input node and the output node.
Embodiment 17. The method of embodiment 14, wherein the first set of control signals is configured to cause the solid-state switching circuit to control a current flow through the first conductive path based on a configuration profile, wherein the configuration profile is associated with current increase rate, a voltage increase rate, an operation status of a load device electrically coupled to the output node, or any combination thereof.
Embodiment 18. The method of embodiment 14, wherein second portion of the electrical current flow is higher than the first portion of the electrical current flow.
Embodiment 19. The method of embodiment 14, wherein the solid-state switching circuit comprises a first solid-state switch, a second solid-state switch, or both, and wherein the first set of control signals is configured to cause the solid-state switching circuit to close the first solid-state switch, the second solid-state switch, or both.
Embodiment 20. The method of embodiment 14, wherein the second set of control signals is configured to cause the breaker switch to close a mechanical switch of the breaker switch.

## Claims

1. A circuit breaker system comprising:
a disconnector switch;
a breaker switch coupled in series with the disconnector switch, wherein an input node is configured to electrically connect to an output node via the disconnector switch and the breaker switch through a first conductive path;
a solid-state switching circuit coupled in parallel with the breaker switch, wherein the solid-state switching circuit comprises at least one solid-state switch, and wherein the input node is configured to electrically connect to the output node via the disconnector switch and the at least one solid-state switch through a second conductive path; and
a processor configured to perform operations comprising:
providing a first set of control signals to the disconnector switch to close when the breaker switch and the solid-state switching circuit are open;
providing a second set of control signals to the solid-state switching circuit to cause the solid-state switching circuit to close and connect the input node to the second conductive path;
providing a third set of control signals to the breaker switch to cause the breaker switch to close and connect the input node to the first conductive path; and
providing a fourth set of control signals to the solid-state switching circuit to cause the solid-state switching circuit to open and disconnect the input node from the second conductive path.

2. The circuit breaker system of claim 1, wherein the breaker switch comprises a magnetic actuator configured to open and close the breaker switch.

3. The circuit breaker system of claim 1 or 2, comprising a voltage sensor, a current sensor, or both, wherein the processor is configured to perform the operations comprising:
receiving one or more measurement signals from the voltage sensor, the current sensor, or both,; and
providing the first set of control signals, the second set of control signals, the third set of control signals, the fourth set of control signals, or any combination thereof based on the one or more measurement signals.

4. The circuit breaker system of one of claims 1 to 3, wherein the solid-state switching circuit comprises a first solid-state switch and a second solid-state switch.

5. The circuit breaker system of claim 4, wherein a drain of the first solid-state switch is coupled to the disconnector switch, a source of the first solid-state switch is coupled to a drain of the second solid-state switch, and a source of the second solid-state switch is coupled to the output node.

6. The circuit breaker system of one of claims 1 to 5, comprising providing the first set of control signals to the disconnector switch when the breaker switch and the solid-state switching circuit are open.

7. A method comprising:
receiving, by a processor, a request to interrupt electrical current flow of a first conductive path of a circuit breaker system, wherein the circuit breaker system comprises a breaker switch and a disconnector switch configured to provide the first conductive path between an input node and an output node of the circuit breaker system, wherein the request is received when the breaker switch and the disconnector switch are closed, and wherein the breaker switch is coupled in series with the disconnector switch;
transmitting, by the processor, a first set of control signals to a solid-state switching circuit of the circuit breaker system, wherein the first set of control signals is configured to cause the solid-state switching circuit to close, thereby providing a second conductive path between the input node and the output node, wherein the second conductive path comprises the disconnector switch and the solid-state switching circuit, wherein the solid-state switching circuit is coupled in series with the disconnector switch and in parallel with the breaker switch;
transmitting, by the processor, a second set of control signals to the breaker switch, wherein the second set of control signals is configured to cause the breaker switch to open, thereby diverting at least a portion of the electrical current flow through the second conductive path; and
transmitting, by the processor, a third set of control signals to the solid-state switching circuit, wherein the third set of control signals is configured to cause the solid-state switching circuit to open, thereby reducing the electrical current flow through the circuit breaker system.

8. The method of claim 7, comprising transmitting, by the processor, a fourth set of control signals in response to opening the solid-state switching circuit, wherein the fourth set of control signals is configured to cause the disconnector switch to open and interrupt the electrical current flow through the circuit breaker system; and/or
wherein the fourth set of control signals is configured to cause the disconnector switch to open a mechanical switch of the disconnector switch via a magnetic actuator.

9. The method of claim 8, wherein the fourth set of control signals is configured to cause the disconnector switch to provide an air gap between the input node and the output node by opening the disconnector switch.

10. The method of one of claims 7 to 9, comprising transmitting the third set of control signals to the solid-state switching circuit to cause the solid-state circuit switch to open after opening the breaker switch.

11. The method of one of claims 7 to 10, wherein transmitting the first set of control signals comprises transmitting the first set of control signals to a first solid-state switch, a second solid-state switch, or both of the solid-state switching circuit, wherein the first set of control signals is configured to cause the solid-state switching circuit to close; or
wherein transmitting the first set of control signals comprises transmitting the second set of control signals to an actuator configured to open a mechanical switch associated with the breaker switch.

12. A method comprising:
receiving, by a processor, a request to conduct electrical current flow through a circuit breaker system;
transmitting, by the processor, a first set of control signals to a solid-state switching circuit of the circuit breaker system in response to receiving the request, wherein the first set of control signals is configured to cause the solid-state switching circuit to provide a first conductive path between an input node and an output node of the circuit breaker system;
transmitting, by the processor, a second set of control signals to a breaker switch of the circuit breaker system coupled in parallel to the solid-state switching circuit, wherein the second set of control signals is configured to cause the breaker switch to provide a second conductive path between the input node and the output node and divert a first portion of the electrical current flow to the second conductive path when the solid-state switching circuit is closed; and
transmitting, by the processor, a third set of control signals to the solid-state switching circuit, wherein the third set of control signals is configured to cause the solid-state switching circuit to open the first conductive path, thereby diverting a second portion of the electrical current flow to the second conductive path.

13. The method of claim 12, comprising transmitting, by the processor, a fourth set of control signals to a disconnector switch coupled in series to the breaker switch before transmitting the first set of control signals, wherein the fourth set of control signals to is configured to cause the disconnector switch to close; and/or
wherein the disconnector switch is configured to provide an air gap between the input node and the output node.

14. The method of one of claims 12 to 13, wherein the first set of control signals is configured to cause the solid-state switching circuit to control a current flow through the first conductive path based on a configuration profile, wherein the configuration profile is associated with current increase rate, a voltage increase rate, an operation status of a load device electrically coupled to the output node, or any combination thereof.

15. The method of one of claims 12 to 14, wherein second portion of the electrical current flow is higher than the first portion of the electrical current flow; or
wherein the solid-state switching circuit comprises a first solid-state switch, a second solid-state switch, or both, and wherein the first set of control signals is configured to cause the solid-state switching circuit to close the first solid-state switch, the second solid-state switch, or both; or
wherein the second set of control signals is configured to cause the breaker switch to close a mechanical switch of the breaker switch.
